# EUROPÄISCHE PATENTSCHRIFT

(11) **EP 0 477 493 B1**
(45) Veröffentlichungstag und Bekanntmachung des Hinweises auf die Patenterteilung: **14.05.1997**
(21) Anmeldenummer: 91111809.9
(22) Anmeldetag: 16.07.1991
(51) Int. Cl.: C04B 35/00, H01L 39/24, C23F 1/18, B22D 29/00

(54) **Verfahren zur Herstellung von Formkörpern aus Vorstufen oxidischer Hochtemperatursupraleiter**
Process for producing bodies from preforms of oxide high temperature superconductors
Procédé pour la production de corps supraconducteurs à haute température en oxyde façonnés à partir de préformes

(30) Priorität: 17.08.1990 DE 4026015
(43) Veröffentlichungstag der Anmeldung: 01.04.1992
(73) Patentinhaber: HOECHST AKTIENGESELLSCHAFT, 65926 Frankfurt am Main (DE)
(72) Erfinder: Preisler, Eberhard, Dr., W-5042 Erftstadt (DE); Bock, Joachim, Dr., W-5042 Erftstadt (DE)

(56) Entgegenhaltungen:
- EP-A- 0 362 492
- DE-A- 2 828 762
- US-A- 4 025 361

## Beschreibung

Die Schmelzsynthese von Hochtemperatursupraleitermaterialien auf der Basis der Bismut-Strontium-Calciumcuprate ist in DE 38 3o o92 A1 beschrieben. Die danach oder auf andere bekannte Weise herstellbaren "BSCCO" Hochtemperatursupraleiter haben die Zusammensetzung Bi₂(Sr,Ca)₃Cu₂Oₓ ("2-Schichtverbindung"), wobei das Verhältnis von Strontium zu Calcium (2 bis 5) : 1 beträgt (BSCCO steht für Bismut-Strontium-Calcium-Kupfer-Oxid). Außerdem sind "1-Schichtverbindungen" Bi₂(Sr,Ca)₂CuOₓ und "3-Schichtverbindungen" Bi₂(Sr,Ca)₄Cu₃Oₓ als BSCCO-Hochtemperatur-Supraleiter bekannt. Der Sauerstoffindex "x" ist durch die Summe der Wertigkeiten von Bi, Sr, Ca und Cu vorgegeben, aber insoweit variabel, als Bi 3- oder 5-wertig und Cu 1- oder 2-wertig sein können.

In der DE 38 3o o92 A1 ist auch die Herstellung von Formkörpern aus den Bismut-Strontium-Calciumcupraten erwähnt.
Solche Formkörper lassen sich z.B. durch Vergießen in unterschiedlich geformte Kokillen, die vorzugsweise aus Kupfer bestehen, erhalten, wenn die Kokille offen ist - wie z.B. im Falle einer Mulde mit abgeschrägten Seitenwänden oder eines Halbzylinders - und der Form nach eine Entnahme des Gußstücks erlaubt. Wichtig ist auch, daß der Guß bei kalter Form vorgenommen wird, so daß die Abkühlung der erstarrenden Schmelze an der Kokillenwand so rasch erfolgt, daß eine chemische Reaktion mit dem Kupfer der Kokillenwand nicht eintritt. Auch wenn die Kokillenwand flexibel ist und z.B. aus einem dünnen Blech besteht, das nach dem Abkühlen weggebogen werden kann, gibt es keine Probleme.

Wesentlich schwieriger ist die Herstellung komplizierterer Formkörper, die eine weitgehend geschlossene Kokille mit gegebenenfalls komplizierter Form erforderlich machen. In solchen Fällen kann auch das Prinzip einer raschen Abkühlung zur Vermeidung der Wandreaktion nicht immer angewendet werden, weil gegebenenfalls die Kokille vorgeheizt werden muß, um eine zu frühe Erstarrung der einfließenden Schmelze zu vermeiden. In vergleichsweise einfachen Fällen, z.B. bei der Herstellung dickerer zylindrischer Formkörper durch Vergießen in eine rohrförmige Kokille, kann man noch an eine mechanische Entfernung des Mantelmaterials denken, etwa durch Auftrennen der Kokillenwand in 2 Halbschalen. Doch ist dies bereits bei geringeren Durchmessern kein interessantes Verfahren mehr und bei komplizierteren Geometrien wie Ringen oder Spulen nicht mehr anwendbar.

Um eine Schmelze der dem Hochtemperatur-Supraleiter entsprechenden Zusammensetzung nach dem Erstarren in den supraleitenden Zustand zu überführen, ist eine nachträgliche Wärmebehandlung der erstarrten Schmelze von 6 bis 3o Stunden Dauer bei Temperaturen um 8oo°C an Luft oder Sauerstoff notwendig. Es ist jedoch nur ein Metall bekannt, das als Hüllmaterial für BSCCO Hochtemperatur-Supraleiter geeignet und für Sauerstoff bei den Wärmebehandlungstemperaturen durchlässig ist und somit die Umwandlung der erstarrten Schmelze in den erwünschten Hochtemperatur-Supraleiter innerhalb der Metallhülle erlaubt: Silber.
Leider liegt der Schmelzpunkt des Silbers mit 96o,8°C unterhalb der Temperatur, die die Supraleiterschmelze haben muß, um zuverlässig vergossen werden zu können. So würde eine Silberform aufschmelzen, bevor die Supraleiterschmelze erstarrt ist.

Aus diesem Grunde ist man auf Kupferformen angewiesen, da Kupfer das einzige systemimmanente Metall ist, das sich für den vorliegenden Zweck eignet. Allerdings ist eine Entfernung des Kupfers von der erstarrten Schmelze zwingend notwendig.

Nachdem die mechanische Ablösung der Kupferform nur beschrankt praktizierbar ist, liegt deren chemische Auflösung nahe. Dies ist mit Hilfe einer oxidierenden Säure oder einer Säure plus Oxidationsmittel im Prinzip möglich.

Solche Verfahren sind allgemein bekannt. So beschreibt etwa die DE-A-28 28 762 ein Verfahren zur Herstellung geätzter Strukturen in Kupferschichten unter Verwendung einer Ätzmaske und einer Ätzlösung, die Ammoniumsulfat in wäßriger Lösung, Schwefelsäure und Wasserstoffperoxid enthält. Die zu ätzende Kupferschicht ist wenige µm stark, darunter befindet sich eine Schicht aus einem reinen, nicht durch die Ätzlösung angreifbarem Material, wie etwa CaOₓ. Offenbar gelingt die Ätzung jedoch nur mit einer sehr speriell hierauf eingestellten Ätzlösung. Versuche dieser Art sind auch im Zusammenhang mit der Untersuchung von Yttrium-Bariumcuprat-Supraleiterpulvern, die in Kupferrohre verfüllt und durch Tiefziehen und Walzen verdichtet worden waren, bekannt.

Will man jedoch auf gleiche Weise bei den auf Bismut basierenden Supraleitern verfahren, stellt man einen starken Angriff der Säure auch auf den Supraleiter bzw. seine Vorstufe der erstarrten Schmelze fest, sobald an einer Stelle der Kupfermantel aufgelöst und die Oberfläche der erstarrten Schmelze freigelegt ist. Es zeigt sich nämlich, daß die supraleitenden Bismutverbindungen säurelöslich sind.

Es ist Aufgabe der vorliegenden Erfindung, einen Weg anzugeben, der eine Auflösung des Kupfermantels erlaubt, ohne den darunterliegenden Supraleiter bzw. dessen Vorstufe nennenswert anzugreifen.

Diese Aufgabe wurde durch einen Zusatz von Sulfationen zu der die oxidierende Säure bzw. eine nichtoxidierende Säure und ein Oxidationsmtitel enthaltenden Lösung gelöst. Das dieser Erfindung zugrundeliegende Prinzip ist die Ausbildung einer einen weiteren Angriff der Säure auf die supraleitende Verbindung unterdrückenden Schutzschicht aus Strontium- und/oder Calciumsulfat aus dem dem Elektrolyten zugegebenen Sulfat und den in der Supraleiterverbindung enthaltenen Erdalkalimetallen.

Im einzelnen betrifft die Erfindung nunmehr ein Verfahren zur Herstellung von Formkörpern aus Vorstufen oxidischer Hochtemperatursupraleiter vom Typ BSCCO, welches dadurch gekennzeichnet ist, daß man eine Kupferkokille der gewünschten Form, welche eine erstarrte Bismut-Strontium-Calciumcuprat-Schmelze umhüllt und eine oder mehrere Öffnungen aufweist, bis zur Auflösung der Kupferkokille mit einer Lösung aus einer löslichen Sulfatanionen enthaltenden Verbindung mit Konzentrationen von 100 bis 300 g löslicher Sulfatverbindung je Liter Lösung, einer 10 bis 20 %igen wäßrigen Mineralsäure, ausgewählt aus Salzsäure, Salpetersäure oder Schwefelsäure, und einem Oxidationsmittel behandelt, wobei eine den weiteren Angriff der Säure auf den Formkörper unterdrückende Schutzschicht aus Strontium und/oder Calciumsulfat an dem zugegebenen Sulfat und den in den Formkörpern enthaltenen Erdalkalioxiden gebildet wird.

Darüberhinaus kann das Verfahren der Erfindung bevorzugt oder wahlweise dadurch gekennzeichnet sein, daß man
a) als lösliche, Sulfatanionen enthaltende Verbindung die Sulfate des Natriums, Kaliums, Ammoniums, Magnesiums oder Zinks einsetzt;
b) als Oxidationsmittel Wasserstoffperoxid oder Alkalichlorat einsetzt;
c) gleichzeitig als wäßrige Mineralsäure und als Oxidationsmittel Salpetersäure einsetzt;
d) gleichzeitig als wäßrige Mineralsäure und als Sulfatanionen enthaltende Verbindung Schwefelsäure einsetzt;
e) die Kupferkokille mit einer Lösung aus wäßriger Salpetersäure und Natriumsulfat auflöst;
f) die Kupferkokille mit einer Lösung aus wäßriger Schwefelsäure und Wasserstoffperoxid auflöst;
g) die Behandlung bei 15 bis 80 °C durchführt.

Die Menge der einzusetzenden, Sulfatanionen enthaltenden Verbindung kann an sich gering sein, es muß lediglich das Löslichkeitsprodukt von Calciumsulfat und Strontiumsulfat in Gegenwart von Mineralsäure und Oxidationsmittel und bei der gewählten Temperatur überschritten werden. 2 g lösliche Sulfat-Verbindung, z.B. Na₂SO₄ je Liter Lösung zeigen bereits deutlich die gewünschten Effekte, doch arbeitet man bevorzugt mit Konzentrationen von 1oo bis 3oo g löslicher Sulfat-Verbindung je Liter Lösung.

Die Säurekonzentration, die Behandlungstemperatur und die Behandlungsdauer sind nicht ausschlaggebend. Im allgemeinen erfordern geringe Säurekonzentration und niedrige Behandlungstemperatur eine längere Behandlungsdauer und umgekehrt. Im übrigen hängt die Behandlungsdauer entscheidend von der Dicke der aufzulösenden Kokillenwand ab.

Man kann beispielsweise mit 1o bis 32 gew%iger HNO₃, 1o bis 2o gew%iger HCl oder 1o bis 35 gew%iger H₂SO₄ arbeiten, jedoch ohne an diese Grenzen gebunden zu sein. Ebensowenig spielt die Konzentration des Oxidationsmittels, z.B. des Wasserstoffperoxids eine Rolle. Es ist lediglich darauf zu achten, daß neben der nicht-oxidierenden Mineralsäure stets noch H₂O₂ vorhanden ist. Deshalb muß H₂O₂ ggf. nach und nach in mehreren Portionen zugegeben werden.

Es liegt selbstverständlich im Rahmen dieser Erfindung, wenn man bei etwas dickeren Kupfer-Formwänden (etwa über 0,5 mm) einen größeren Anteil des Kupfers z.B. in reiner Salpetersäure und gegebenenfalls auch bei erhöhter Temperatur, jedenfalls in Abwesenheit von Sulfationen, auflöst und erst dann, wenn die Gefahr eines lokalen Durchbruchs der Supraleiteroberfläche besteht, auf die erfindungsgemäßen Verfahren überwechselt. In Abwesenheit von Sulfationen können die offenen Stirnwände z.B. mit Wachs versiegelt und so vor dem Angriff der Salpetersäure geschützt werden. Auf diese Weise erhält man reine Kupfernitratlösungen, die nicht durch Sulfat verunreinigt sind. Außerdem erfolgt die Auflösung der Kupferkokille insgesamt in kürzerer Zeit.

Das erfindungsgemäße Verfahren wird im folgenden anhand der Ausführungsform mit Salpetersäure ausführlicher beschrieben:

Der Angriff der Salpetersäure auf die erstarrte Supraleiterschmelze hängt bei gegebener Salpetersäurekonzentration und bei Raumtemperatur von der Konzentration an Sulfationen in der Lösung ab. Die Tabelle 1 gibt die Gewichtsverluste (in % des Anfangsgewichts) für ein kompaktes zylindrisches Probestück von 14 mm Länge und 7 mm Durchmesser (Oberfläche: 3,86 cm²) wieder, wobei die Ätzlösung 1o gew%ige Salpetersäure und 0 bis 5oo g l⁻¹ Natriumsulfat enthielt. Der Versuch wurde bei Raumtemperatur durchgeführt.

Beispiele mit * markiert fallen ausserhalb des Bereichs von Anspruch 1.

**TABELLE 1**

| Inhibitionswirkung von Natriumsulfatzusätzen auf die Auflösung von BSCCO 2212 (Bi₂Sr₂CaCu₂Oₓ) in Salpetersäure (1o %) | | | | | | | | |
|---|---|---|---|---|---|---|---|---|
| Nr. | Na₂SO₄ (wasserfrei) g·l¹⁻ | Gewichtsverlust (%) nach | | | | | | |
| | | 5' | 15' | 3o' | 1 h | 2 h | 4 h | 8 h |
| * 1 | 0 | 3,2 | 9,6 | 18,9 | 30,4 | 43,7 | 68,1 | n.b. |
| 2 | 100 | 0,1 | 0,15 | 0,23 | 0,32 | 0,39 | 0,50 | 0,65 |
| 3 | 200 | 0 | 0 | 0,02 | 0,15 | 0,32 | 0,76 | 1,42 |
| 4 | 300 | 0 | 0 | 0,04 | 0,12 | 0,26 | 0,45 | 0,90 |
| * 5 | 400 | 0 | 0 | 0 | 0 | 0 | 0,04 | 0,16 |
| * 6 | 500 | 0 | 0 | 0 | 0 | 0 | 0,03 | 0,08 |
| n.b. = nicht bestimmt | | | | | | | | |

Durch Zugabe von Natriumsulfat zur 1o %igen Salpetersäure wird allerdings auch die Auflösungsgeschwindigkeit des Kupfers vermindert:

**TABELLE 2**

| Auflösung eines leeren Kupferrohrstückes mit einer vergleichbaren Oberfläche wie bei BSCCO 2212 in Tabelle 1 bei verschiedenen Natriumsulfatkonzentrationen | | | | |
|---|---|---|---|---|
| Nr. | Na₂SO₄ (wasserfrei) g·l¹⁻ | Gewichtsverlust (%) nach | | |
| | | 3o' | 2 h | 8 h |
| * 1 | 0 | 0,3 | 3,8 | 11 |
| 2 | 100 | 0,1 | 0,6 | 3,3 |
| 3 | 200 | 0,04 | 0,26 | 1,7 |
| 4 | 300 | 0 | 0 | 0 |

Bei 1o %iger Salpetersäure und 1oo g Natriumsulfat erreicht man bereits einen erheblichen Schutz des BSCCO-Kerns, jedoch sind die Auflösungsraten des Kupfers für technische Zwecke noch sehr klein. Günstiger liegen die Verhältnisse bei Verwendung 2o %iger Salpetersäure, die in Tabelle 3 sowohl für die BSCCO- als auch für die Kupferauflösung (in Klammern) dargestellt sind.

**TABELLE 3**

| Inhibitionswirkung von Natriumsulfat auf die Auflösung von BSCCO 2212 und Kupfer (...) in 2o %iger Salpetersäure bei Raumtemperatur | | | | | | | |
|---|---|---|---|---|---|---|---|
| Nr. | Na₂SO₄ (wasserfrei) g·l⁻¹ | Gewichtsverlust (%) nach | | | | | |
| | | 15' | 3o' | 1 h | 2 h | 4 h | 8 h |
| * 1 | 0 | 25 (18) | 44 (34) | 72 (6o) | 1oo(1oo) | 1oo(1oo) | 1oo(1oo) |
| 2 | 100 | 1,7(12) | 2 (23) | 2,3(42) | 2,5( 87) | 2,7(1oo) | 3,o(1oo) |
| 3 | 200 | 0,2( 9) | 0,2(18) | 0,4(35) | 0,7( 74) | 0,9(1oo) | 1,3(1oo) |
| 4 | 300 | 0 ( 6) | 0 (13) | 0 (25) | 0 ( 52) | 0,2( 79) | 0,2(1oo) |
| * 5 | 400 | 0 ( 4) | 0 ( 9) | 0 (17) | 0 ( 31) | 0 ( 4o) | 0,2( 52) |
| * 6 | 500 | 0 ( 2) | 0 ( 4) | 0 ( 7) | 0 ( 9) | 0 ( 12) | 0 ( 18) |

Die Auflösung in 32 %iger Salpetersäure bei Raumtemperatur ist in Tabelle 4 wiedergegeben (mit den Werten für Kupfer wiederum in Klammern):

**TABELLE 4**

| Inhibitionswirkung von Natriumsulfat auf die Auflösung von BSCCO 2212 und Kupfer (...) in 32 %iger Salpetersäure bei Raumtemperatur | | | | | | |
|---|---|---|---|---|---|---|
| Nr. | Na₂SO₄ (wasserfrei) g·l⁻¹ | Gewichtsverlust (%) nach | | | | |
| | | 15' | 3o' | 1 h | 2 h | 4 h |
| * 1 | 100 | 0,51 (71) | 1,7 (100) | 4,4 (100) | 9 (100) | 20 (100) |
| * 2 | <200⁺ | 0,13 (38) | 0 ( 45) | 0,12 (59) | 3 ( 7o) | 9 ( 87) |

| | | | | | | |
|---|---|---|---|---|---|---|
| ⁺200 g Na₂SO₄ sind in 32 %iger HNO₃ nicht mehr vollständig löslich. | | | | | | |

Aus diesen Versuchen ergibt sich, daß eine Kombination von 2o %iger Salpetersäure mit 2oo bis 3oo g Natriumsulfat eine Art Optimum darstellt, bei dem eine noch brauchbare Auflösungsgeschwindigkeit mit einer guten Schutzwirkung verbunden ist. Natürlich ist - bei ständiger visueller Kontrolle - auch eine 32 %ige Salpetersäure mit 1oo g Natriumsulfat geeignet. In einer an Natriumsulfat gesättigten Lösung allerdings löst sich Kupfer viel langsamer auf, weil bei zunehmender Auflösung des Kupfers alsbald auch Kupfersulfat auskristallisiert, das sich leicht auf der Kupferoberfläche ablagert und die weitere Auflösung hemmt bzw. verungleichmäßigt.

### Erhöhte Temperatur:

Der Einfluß erhöhter Temperatur wurde in 1o %iger Salpetersäure geprüft:

**TABELLE 5**

| Inhibitionswirkung von Na₂SO₄ auf die Auflösung von BSCCO 2212 und Kupfer in 1o %iger Salpetersäure bei 7o°C (Werte für Kupfer in Klammern) | | | | | | | |
|---|---|---|---|---|---|---|---|
| Nr. | Na₂SO₄ wasserfrei g·l⁻¹ | Gewichtsverlust (%) nach | | | | | |
| | | 15' | 3o' | 1 h | 2 h | 4 h | 8 h |
| 1 | 100 | 0,45(17) | 0,77(32) | 1,1 (59) | 1,4(100) | 2,1(100) | 2,9(100) |
| 2 | 300 | 0 ( 3) | 0,16( 7) | 0,22(14) | 0,5( 27) | 0,7( 58) | 0,7( 92) |
| * 3 | 500 | 0 ( 0) | 0 ( 0) | 0 ( 0) | - | - | - |

Auch hier erhält man bei 1oo bis 3oo g Natriumsulfat im Liter günstige Ergebnisse. Sie entsprechen im wesentlichen denen, die man bei Raumtemperatur mit 2o %iger Salpetersäure erhält.

Im Prinzip sind auch andere Lösungen denkbar, welche den gleichen Effekt wie Salpetersäure haben:
a) Schwefelsäure + Wasserstoffperoxid
b) Salzsäure + Wasserstoffperoxid
c) Salzsäure + Alkalichlorat

Die Eignung der Kombination von Schwefelsäure mit einem Oxidationsmittel wird an 2o %iger Schwefelsäure mit 1o %igem Wasserstoffperoxid bei Raumtemperatur gezeigt. Hierbei ist der Zusatz eines Sulfats nicht notwendig, da die benötigten Sulfatanionen von der Schwefelsäure selbst zur Verfügung gestellt werden.

**TABELLE 6**

| Unterschiede in der Auflösung von BSCCO 2212 und Kupfer in 2o %iger Schwefelsäure unter Zusatz von 1o %iger H₂O₂ bei Raumtemperatur | | | | | |
|---|---|---|---|---|---|
| Zeit: | 5' | 15' | 1 h | 2 h | 4 h |
| Gewichtsverlust Cu/% | 9,8 | 18 | 51 | 76 | 100 |
| Gewichtsverlust BSCCO/% | 0,2 | 0,4 | 0,55 | 0,75 | 1,02 |

### Beispiel 1 (Vergleichsbeispiel)

Ein Kupferrohr mit einer Länge von 1o cm, einer Wandstärke von 1 mm und einer lichten Weite von 8 mm, das einen Kern aus einer erstarrten BSCCO Hochtemperatur-Supraleiterschmelze der Formel Bi₂Sr₂CaCu₂Oₓ enthält, wird bei Raumtemperatur in 2o %ige Salpetersäure gelegt und unter Rühren darin belassen, bis der Kupfermantel zu einem Teil abgeätzt ist (2.8 h) und ein Teil des Kerns freiliegt. Die Oberfläche des Kerns zeigt tiefe Löcher und ist an den Stirnflächen, wo der Kern ungeschützt der Wirkung der Salpetersäure ausgesetzt war, mehrere mm weit weggelöst.

### Beispiel 2

Beispiel 1 wurde wiederholt, jedoch wurden 3oo g Natriumsulfat in 1 Liter 2o %iger Salpetersäure aufgelöst. Nach 3 Stunden war noch kein Durchbruch des Kerns zu beobachten, an den freiliegenden Stirnflächen hatte sich ein dichter weißer Film gebildet, der die ursprüngliche Oberfläche bedeckte. Nach 12 Stunden war das Kupfer heruntergelöst und der gesamte Kern war nun mit der weißen, dünnen Deckschicht belegt. Anzeichen eines ungleichmäßigen Abtrags oder Lochfraß wurden nicht beobachtet.

### Beispiel 3

Ein gleicher Stab wie in Beispiel 1 wurde mit 2oo ml 2o %iger Schwefelsäure, der 3o ml 1o gew%iger Wasserstoffperoxid, aufgeteilt in 3 gleiche Portionen, nach und nach zugesetzt wurde, in Berührung gebracht, wobei Kupfer in Lösung ging. Die Lösung wurde mittels eines Magnetrührers gerührt, die Temperatur lag bei 25°C. Nach 15 Stunden Kontaktzeit war der Kupfermantel aufgelöst. Der Supraleiterkern zeigte keinen Säureangriff auf seiner Oberfläche, die gleichmäßig mit Erdalkalisulfat bedeckt war.

## Patentansprüche

1. Verfahren zur Herstellung von Formkörpern aus Vorstufen oxidischer Hochtemperatursupraleiter vom Typ BSCCO, dadurch gekennzeichnet, daß man eine weitgehend geschlossene Kupferkokille mit ggf. komplizierter Form, welche eine erstarrte Bismut-Strontium-Calciumcuprat-Schmelze umhüllt und eine oder mehrere Öffnungen aufweist, bis zur Auflösung der Kupferkokille mit einer Lösung aus einer löslichen, Sulfatanionen enthaltenden Verbindung mit Konzentrationen von 100 bis 300 g löslicher Sulfat-Verbindung je Liter Lösung, einer 10 bis 20 %igen wäßrigen Mineralsäure, ausgewählt aus Salzsäure, Salpetersäure oder Schwefelsäure und einem Oxidationsmittel behandelt, wobei eine den weiteren Angriff der Säure auf den Formkörper unterdrückende Schutzschicht aus Strontium- und/oder Calciumsulfat aus dem zugegebenen Sulfat und den in den Formkörpern enthaltenen Erdalkalioxiden gebildet wird.

2. Verfahren nach Anspruch 1, dadurch gekennzeichnet, daß man als lösliche, Sulfatanionen enthaltende Verbindung der Sulfate des Natriums, Kaliums, Ammoniums, Magnesiums oder Zinks einsetzt.

3. Verfahren nach Anspruch 1 oder 2, dadurch gekennzeichnet, daß man als Oxidationsmittel Wasserstoffperoxid oder Alkalichlorat einsetzt.

4. Verfahren nach Anspruch 1 oder 2, dadurch gekennzeichnet, daß man gleichzeitig als wäßrige Mineralsäure und als Oxidationsmittel Salpetersäure einsetzt.

5. Verfahren nach Anspruch 1 oder 2, dadurch gekennzeichnet, daß man gleichzeitig als wäßrige Mineralsäure und als Sulfatanionen enthaltende Verbindung Schwefelsäure einsetzt.

6. Verfahren nach Anspruch 4, dadurch gekennzeichnet, daß man die Kupferkokille mit einer Lösung aus wäßriger Salpetersäure und Natriumsulfat auflöst.

7. Verfahren nach Anspruch 5, dadurch gekennzeichnet, daß man die Kupferkokille mit einer Lösung aus wäßriger Schwefelsäure und Wasserstoffperoxid auflöst.

8. Verfahren nach mindestens einem der vorhergehenden Ansprüche, dadurch gekennzeichnet, daß man die Behandlung bei 15 bis 80 °C durchführt.

## Claims

1. A process for producing molded bodies from precursors of oxidic high-temperature superconductors of the BSCCO type, wherein a substantially closed copper mold, which encloses a solidified bismuth strontium calcium cuprate melt, has one or more openings and may have a complex shape, is treated with a solution of a soluble compound containing sulfate anions with concentrations of from 100 to 300 g of soluble sulfate compound per liter of solution, a 10 to 20% strength aqueous mineral acid selected from hydrochloric acid, nitric acid and sulfuric acid and an oxidizing agent until the copper mold is dissolved, a protective layer which suppresses further attack of the molding by the acid and comprises strontium sulfate and/or calcium sulfate being formed from the added sulfate and the alkaline earth metal oxides contained in the moldings.

2. The process as claimed in claim 1, wherein the sulfates of sodium, potassium, ammonium, magnesium or zinc are used as soluble compound containing sulfate anions.

3. The process as claimed in claim 1 or 2, wherein hydrogen peroxide or alkali chlorate is used as oxidizing agent.

4. A process as claimed in claim 1 or 2, wherein nitric acid is simultaneously used as aqueous mineral acid and as oxidizing agent.

5. A process as claimed in claim 1 or 2, wherein sulfuric acid is simultaneously used as aqueous mineral acid and as compound containing sulfate anions.

6. The process as claimed in claim 4, wherein the copper mold is dissolved with a solution of aqueous nitric acid and sodium sulfate.

7. A process as claimed in claim 5, wherein the copper mold is dissolved with a solution of aqueous sulfuric acid and hydrogen peroxide.

8. A process as claimed in at least one of the preceding claims, wherein the treatment is carried out at 15 to 80°C.

## Revendications

1. Procédé de production de corps moulés à partir de précurseurs de supraconducteurs à haute température du type BSCCO, caractérisé en ce qu'on traite une coquille de cuivre largement fermée avec le cas échéant une forme compliquée, qui enrobe une masse fondue solidifiée de cuprate de bismuthstrontium-calcium et présente un ou plusieurs orifices, jusqu'à dissolution de la coquille de cuivre avec une solution d'un composé soluble contenant des anions sulfates avec des concentrations de 100 à 300 g de composé de sulfate soluble par litre de solution, d'un acide minéral en solution aqueuse à 10 à 20 %, choisi parmi l'acide chlorhydrique, l'acide nitrique ou l'acide sulfurique et un oxydant, en formant une couche protectrice empêchant la poursuite de l'attaque de l'acide sur le corps moulé, couche qui est en sulfate de strontium et/ou de calcium formé à partir du sulfate ajouté et des oxydes de métaux alcalino-terreux contenus dans les corps moulés.

2. Procédé selon la revendication 1, caractérisé en ce qu'on utilise comme composé soluble contenant des anions sulfates des sulfates de sodium, potassium, ammonium, magnésium ou zinc.

3. Procédé selon la revendication 1 ou 2, caractérisé en ce qu'on utilise comme oxydant du peroxyde d'hydrogène ou du chlorate d'alcalin.

4. Procédé selon la revendication 1 ou 2, caractérisé en ce qu'on utilise simultanément comme solution aqueuse d'acide minéral et comme oxydant de l'acide nitrique.

5. Procédé selon la revendication 1 ou 2, caractérisé en ce qu'on utilise simultanément comme solution aqueuse d'acide minéral et comme composé contenant des ions sulfates de l'acide sulfurique.

6. Procédé selon la revendication 4, caractérisé en ce qu'on dissout la coquille de cuivre avec une solution aqueuse d'acide nitrique et de sulfate de sodium.

7. Procédé selon la revendication 5, caractérisé en ce qu'on dissout la coquille de cuivre avec une solution aqueuse d'acide sulfurique et du peroxyde d'hydrogène.

8. Procédé selon au moins l'une des revendications précédentes, caractérisé en ce qu'on réalise le traitement entre 15 et 80°C.
